# EUROPÄISCHE PATENTSCHRIFT

(11) **EP 2 684 433 B1**
(45) Veröffentlichungstag und Bekanntmachung des Hinweises auf die Patenterteilung: **05.12.2018**
(21) Anmeldenummer: 12707325.2
(22) Anmeldetag: 07.03.2012
(51) Int. Cl.: H05K 1/18, H05K 3/32, H01G 2/06, H01G 4/248, H02K 5/22, H02K 11/00

(54) **BAUGRUPPE MIT EINEM TRÄGER, EINEM SMD-BAUTEIL UND EINEM STANZGITTERTEIL**
ASSEMBLY HAVING A SUBSTRATE, AN SMD COMPONENT, AND A LEAD FRAME PART
MODULE COMPRENANT UN SUPPORT, UN COMPOSANT CMS ET UNE PARTIE GRILLE ESTAMPÉE

(30) Priorität: 09.03.2011 DE 102011013449
(43) Veröffentlichungstag der Anmeldung: 15.01.2014
(73) Patentinhaber: Continental Automotive GmbH, 30165 Hannover (DE)
(72) Erfinder: WALLRAFEN, Werner, 65719 Hofheim (DE)
(86) Internationale Anmeldenummer: PCT/EP2012/053887
(87) Internationale Veröffentlichungsnummer: WO 2012/120032

(56) Entgegenhaltungen:
- EP-B1- 1 624 550
- WO-A1-98/44769
- DE-A1- 10 129 118
- JP-A- 5 109 575
- JP-A- 9 289 365
- US-A1- 2005 239 331
- US-B1- 6 768 243

## Beschreibung

Die Erfindung betrifft eine Baugruppe mit einem Träger aus einem elektrisch isolierenden Material, einem SMD-Bauteil, das seitliche Kontaktflächen aufweist, und einem Stanzgitterteil aus Metall, das an dem Träger befestigt ist und zur Herstellung von elektrischen Verbindungen zwischen den seitlichen Kontaktflächen des SMD-Bauteils und weiteren Funktionselementen der Baugruppe dient.

SMD-Bauteile (SMD: surface mounted device) zeichnen sich gegenüber bedrahteten elektronischen Bauteilen durch ihre kompakte Bauform und einfache Bestückung aus. Standardmäßig werden sie auf Leiterplatten oder Keramiksubstraten aufgebracht und mit Leiterbahnen der Leiterplatten verlötet. Die Leiterbahnen müssen dann ihrerseits mit weiteren elektrischen Anschlüssen verbunden werden, insbesondere über Anschlusskabel oder -drähte. Falls nur wenige SMD-Bauteile für eine bestimmte Baugruppe benötigt werden, ist diese Art der Montage sehr aufwendig und kostenintensiv und benötigt viel Bauraum. Ein Beispiel sind EMV-Filter zur Verbesserung der elektromagnetischen Verträglichkeit (EMV) von Gleichstrom-Elektromotoren. Bei derartigen Anwendungen ist die Kontaktierung der Leiterbahnen der Leiterplatte bzw. eines Keramiksubstrates mit weiteren stromführenden Komponenten sehr aufwendig und benötigt viel Platz in Bereichen, in denen kaum Bauraum zur Verfügung steht.

Aus dem US-Patent Nr. US 6,903,920 B1 ist bekannt geworden, einen SMD-Keramikkondensator vor mechanischen Belastungen zu schützen, indem er mit Hilfe metallischer Sockelteile auf einer Leiterplatte befestigt wird. Die Sockelteile bestehen aus U-förmig gebogenen Kupferstreifen, deren eines Ende mit seitlichen Kontaktflächen des SMD-Keramikkondensators verlötet ist. Diese Verbindung erfolgt vor der Montage des Kondensators auf einer Leiterplatte. Anschließend werden die freien Enden der Sockelteile mit Leiterbahnen der Leiterplatte verlötet.

Aus der Druckschrift GB 2 416 928 A ist ein Halter für ein EMV-Filter bekannt geworden. Das EMV-Filter besteht aus einer Anordnung von Keramikkondensatoren in einem SMD-Gehäuse mit vier seitlichen Kontaktflächen. Der Halter weist eine von vier Wänden umgebene Aufnahme für das Filter auf. Auf jede der die Aufnahme umgebenden Wände ist eine Federklemme aufgesetzt. Ein innerhalb der Aufnahme liegendes Ende der Federklemme kontaktiert die seitlichen Kontaktflächen des Filters. Die außen liegenden Enden werden über weitere Kontaktstellen angeschlossen.

Außerdem ist es bekannt geworden, SMD-Keramikkondensatoren ohne eine gesonderte Leiterplatte oder ein Keramiksubstrat unmittelbar mit einem sogenannten Leadframe, einem Stanzgitterteil aus Metall, zu verbinden. Insbesondere können die Kondensatoren direkt mit dem Leadframe verlötet werden. Diese Verbindungstechnik führt zu hohen mechanischen Belastungen der Keramikkondensatoren, die insbesondere bei gleichzeitigen Temperaturschwankungen in einem Betriebstemperaturbereich von beispielsweise -50 °C bis +160 °C zu einer Beschädigung oder Zerstörung der Kondensatoren aufgrund unterschiedlicher Wärmeausdehnungskoeffizienten führen können.

Die US 6 768 243 B1 betrifft eine Motorbürstenanordnung mit elektrischer Geräuschüberbrückung.

Die JP 9 289 365 A betrifft eine Befestigungsstruktur für ein Kapazitätselement und einen Impedanzübereinstimmungskreis eines Leistungsverstärkers.

Aus der EP 164 550 B1 ist ein Träger für Unterdrückungschips bekannt.

Die JP 5 109 575 A betrifft ein Herstellungsverfahren einer elektronischen Komponente.

Die DE 199 29 118 A1 betrifft ein Gehäuseteil für einen elektrischen Verstellantrieb.

Aus der WO 98/44769 A1 sind gegossene Aufnahmen für elektronische Komponentenbefestigungen bekannt

Die US 2005/239331 A1 offenbart eine Motoranordnung von X2Y RFI-Dämpfungskondensatoren.

Davon ausgehend ist es die Aufgabe der Erfindung, eine Baugruppe mit den Merkmalen des Oberbegriffs des Anspruchs 1 zur Verfügung zu stellen, deren Bestandteile kostengünstig hergestellt und einfach zusammengesetzt werden können und die auch unter hohen mechanischen und thermischen Belastungen robust und zuverlässig einsetzbar ist.

Diese Aufgabe wird gelöst durch die Baugruppe mit den Merkmalen des Anspruchs 1. Vorteilhafte Ausgestaltungen sind in den sich anschließenden Unteransprüchen angegeben. Die Baugruppe hat
- einen Träger aus einem elektrisch isolierenden Material,
- ein SMD-Bauteil, das seitliche Kontaktflächen aufweist, und
- ein Stanzgitterteil aus Metall, das an dem Träger befestigt ist und zur Herstellung von elektrischen Verbindungen zwischen den seitlichen Kontaktflächen des SMD-Bauteils und weiteren Funktionselementen der Baugruppe dient, wobei
- das Stanzgitterteil Kontaktzungen aufweist, die federnd an den seitlichen Kontaktflächen anliegen und stoffschlüssig mit den seitlichen Kontaktflächen verbunden sind.

Das SMD-Bauteil ist relativ zu dem Träger in einer vorgegebenen Position angeordnet. Beispielsweise kann es an einer Oberseite des Trägers anliegen oder sich ein einem Abstand davon befinden.

Das Stanzgitterteil besteht aus Metall, insbesondere aus Kupfer oder einer kupferhaltigen Legierung. Das Material des Stanzgitterteils weist federelastische Eigenschaften auf und die Kontaktzungen sind ebenfalls federelastisch. Das Stanzgitterteil kann durch Stanzen aus einem geeigneten Blech hergestellt sein und mehrere Kontaktzungen aufweisen, die in einem Arbeitsgang ausgestanzt werden können. Um das Stanzgitterteil in mehrere elektrisch nicht verbundene Bestandteile zu trennen, können gemeinsam gestanzte Teile nachträglich voneinander getrennt werden. Alternativ können mehrere Stanzteile, die jeweils nur eine Kontaktzunge aufweisen, in ihrer Kombination das Stanzgitterteil bilden.

Das Stanzgitterteil ist an dem Träger, d. h. in seiner relativen Anordnung zu dem Träger fixiert. Es dient zur Herstellung von elektrischen Verbindungen zu weiteren Funktionselementen der Baugruppe. Dies können beispielsweise weitere elektronische Bauteile oder elektromechanische Bestandteile der Baugruppe sein. Ein Beispiel sind Bürstenträger eines Elektromotors. Das Stanzgitterteil kann die elektrische Verbindung zu diesen weiteren Funktionselementen durch einen unmittelbaren elektrischen Kontakt herstellen, d. h. ohne ein gesondertes elektrisches Verbindungselement wie ein Kabel oder einen Draht. Beispielsweise können die Bürsten eines Elektromotors unmittelbar mit dem Stanzgitterteil verbunden sein, oder es kann ein elektrischer Kontakt durch unmittelbares Anliegen der Bürsten oder eines Bürstenträgers an dem Stanzgitterteil bestehen.

Das Stanzgitterteil kann auch als Leadframe bezeichnet werden.

Die Kontaktzungen können einteilig mit dem Stanzgitterteil ausgebildet und insbesondere im selben Stanzvorgang wie die übrigen Bestandteile des Stanzgitterteils hergestellt worden sein. Zusätzlich können in weiteren Verarbeitungsschritten die Kontaktzungen mit einer dünneren Form versehen werden. Alternativ können die Kontaktzungen auch gesondert gefertigt und anschließend mit den übrigen Bestandteilen des Stanzgitterteils verbunden werden, beispielsweise durch Punktschweißen oder Löten.

Die Kontaktzungen liegen federnd an den seitlichen Kontaktflächen des SMD-Bauteils an und sind stoffschlüssig mit diesen verbunden. Die stoffschlüssige Verbindung kann insbesondere durch Löten oder alternativ zum Beispiel durch Leitkleben hergestellt werden. Das Löten kann durch Verzinnen der Kontaktflächen und nachfolgendes Erwärmen nach Anordnen des SMD-Bauteils am Träger erfolgen, d. h. in einem sogenannten Reflow-Lötverfahren. Alternativ kann die stoffschlüssige Verbindung durch Laserlöten erfolgen, also durch gezieltes Erhitzen der zu verbindenden Elemente mit einem Laserstrahl. Die stoffschlüssige Verbindung führt zu einer besonders robusten Anordnung mit einer zuverlässigen Kontaktierung, die insbesondere bei Verschmutzung, hoher Luftfeuchte oder Erschütterungen bestehen bleibt.

Das federnde Anliegen der Kontaktzungen an den seitlichen Kontaktflächen führt in der Regel bereits zu einer elektrischen Verbindung. Diese wird durch die zusätzliche stoffschlüssige Verbindung dauerhaft sichergestellt. Durch das federnde Anliegen kann die Montage der Baugruppe vereinfacht werden, weil das SMD-Bauteil dadurch federnd von den Kontaktzungen in seiner Montageposition gehalten werden kann und in dieser unabhängig von einer nachfolgenden stoffschlüssigen Verbindung verbleibt. Insbesondere bedarf es während des Herstellens der stoffschlüssigen Verbindung nicht notwendigerweise einer zusätzlichen Fixierung des SMD-Bauteils in der Montageposition.

Der Träger weist eine in einer Oberseite ausgebildete Vertiefung auf, in der das SMD-Bauteil angeordnet ist und in die die Kontaktzungen hineinragen. Dass die Kontaktzungen des Stanzgitterteils in die Vertiefung hineinragen bedeutet, dass sie sich mindestens teilweise, insbesondere mit ihren freien Enden, innerhalb der Vertiefung befinden. Das SMD-Bauteil ist in der Vertiefung des Trägers angeordnet, d. h., es befindet sich mindestens teilweise innerhalb der Vertiefung. Es kann vollständig in der Vertiefung angeordnet sein oder nach oben aus der Vertiefung herausragen und über die Oberseite des Trägers überstehen. Die seitlichen Kontaktflächen des SMD-Bauteils können sich mindestens teilweise innerhalb der Vertiefung befinden. Das SMD-Bauteil kann in der Vertiefung befestigt sein, beispielsweise durch Verkleben mit einem Boden der Vertiefung. Es kann auch ausschließlich von den federnden Kontaktzungen in seiner Position gehalten werden, insbesondere während der Montage der Baugruppe.

Die Vertiefung weist einen Boden und seitliche Wandflächen auf, und die Kontaktzungen sind in einem Abstand von den seitlichen Wandflächen angeordnet. Diese Anordnung führt dazu, dass die Kontaktzungen federnd in Richtung zu diesen seitlichen Wandflächen hin verlagert werden können. Hierdurch ist eine federnde Halterung bzw. Kontaktierung des SMD-Bauteils besonders gut möglich und Fertigungstoleranzen können gut ausgeglichen werden.

In einer Ausgestaltung ist der Träger im Spritzgießverfahren hergestellt. Beispielsweise kann er aus einem duroplastischen oder thermoplastischen Kunststoff bestehen. Eine Fertigung im Spritzgießverfahren ist kostengünstig und ermöglicht eine komplexe Formgebung des Trägers. Insbesondere kann die Vertiefung im Träger beim Spritzgießen des Trägers ausgebildet werden.

In einer Ausgestaltung ist der Träger im Spritzgießverfahren mit dem Stanzgitterteil verbunden. Der Träger kann an das Stanzgitterteil angespritzt oder Teile des Stanzgitterteils können mit dem Material des Trägers umgespritzt werden. Dies ermöglicht ebenfalls eine kostengünstige Fertigung und bewirkt eine präzise und dauerhafte Fixierung des Stanzgitterteils gegenüber dem Träger. Insbesondere können sich die Kontaktzungen des Stanzgitterteils bezüglich der Vertiefung exakt in einer vorgegebenen Anordnung befinden.

Grundsätzlich kann das Stanzgitterteil auch auf beliebige andere Art und Weise an dem Träger befestigt sein. Gemäß einer Ausgestaltung ist es mit dem Träger verklebt.

In einer Ausgestaltung ist das Stanzgitterteil an der Oberseite des Trägers befestigt. Es kann insbesondere mit einer an der Oberseite des Trägers befindlichen Fläche verbunden sein, beispielsweise durch Verkleben oder durch Anspritzen des Trägers an das Stanzgitterteil.

In einer Ausgestaltung ragen die Kontaktzungen von der Oberseite aus in die Vertiefung hinein. Grundsätzlich können sie von einer beliebigen Richtung aus in die Vertiefung hineinragen, beispielsweise bei einem teilweise mit dem Material des Trägers umspritzten Stanzgitterteil durch eine seitliche Wandfläche der Vertiefung hindurch. Bei einem Hineinragen von der Oberseite aus kann das Einsetzen des SMD-Bauteils in die Vertiefung vereinfacht und der elektrische Kontakt zwischen den Kontaktzungen und den seitlichen Kontaktflächen des SMD-Bauteils kann besonders einfach und zuverlässig hergestellt werden. Insbesondere können die Kontaktzungen das SMD-Bauteil beim Einsetzen in die Vertiefung in die gewünschte Position führen.

In einer Ausgestaltung sind die seitlichen Wandflächen im Bereich der Kontaktzungen geneigt angeordnet, sodass ein Winkel zwischen einer seitlichen Wandfläche und einer angrenzenden Oberseite im Bereich von 95° bis 140° liegt. Mit anderen Worten erweitert sich die Vertiefung zur Oberseite hin trichterförmig. Dies schafft einen Freiraum für die Kontaktzungen und kann das Einsetzen des SMD-Bauteils weiter vereinfachen.

In einer Ausgestaltung ist an mindestens zwei Seiten der Vertiefung jeweils mindestens eine Kontaktzunge angeordnet. Die zwei Seiten können einander gegenüberliegen. Es können auch Kontaktzungen an drei oder mehr Seiten der Vertiefung angeordnet sein. Die Vertiefung kann insbesondere einen rechteckigen Querschnitt (in einer Querschnittsebene parallel zur Oberseite) aufweisen und vier paarweise einander gegenüberliegende Seiten aufweisen. Von jeder dieser Seiten aus ist eine Kontaktierung einer seitlichen Kontaktfläche des SMD-Bauteils möglich. Beispielsweise können zwei Kontaktzungen vorhanden sein, die an gegenüberliegenden Seiten der Vertiefung angeordnet sind. Es können jedoch auch drei oder mehr Kontakte durch eine entsprechende Anzahl von Kontaktzungen hergestellt werden.

In einer Ausgestaltung weisen die Kontaktzungen einen Abschnitt auf, der um einen Rand der Vertiefung herum gekrümmt ist und in einem Abstand von dem Rand, von einer seitlichen Wandfläche der Vertiefung und von der Oberseite des Trägers angeordnet ist. Der gekrümmte Abschnitt kann im Wesentlichen kreisbogenförmig sein und/oder einen gleichmäßigen Abstand von den genannten Elementen des Trägers einhalten. Durch die Krümmung ergeben sich gute federelastische Eigenschaften der Kontaktzungen, gegebenenfalls auch bei Verwendung eines relativ starren Materials für die Kontaktzungen. Außerdem wird einer Beschädigung der empfindlichen SMD-Bauteile entgegengewirkt.

In einer Ausgestaltung weisen die Kontaktzungen eine Materialstärke auf, die geringer ist als die Materialstärke des Stanzgitterteils in einem von der Vertiefung entfernten Abschnitt. Die Materialstärke des Stanzgitterteils kann beispielsweise im Bereich von 0,3 mm bis 1,2 mm liegen, insbesondere im Bereich von 0,4 mm bis 1 mm. Die Materialstärke der Kontaktzungen kann beispielsweise im Bereich von 0,05 mm bis 0,3 mm, insbesondere im Bereich von 0,1 mm bis 0,2 mm liegen. Diese Verringerung der Materialstärke kann beispielsweise durch Walzen oder Pressen der Kontaktzungen nach dem ersten Stanzvorgang und ein weiteres Ausstanzen bewirkt werden. Insbesondere kann sich die Materialstärke von einem von der Vertiefung entfernten Abschnitt bis zu einem angelenkten und/oder freien Abschnitt der Kontaktzungen kontinuierlich verringern.

In einer Ausgestaltung sind die Kontaktzungen durch Verformen und Schneiden eines Stanzgitterteils einstückig mit dem Stanzgitterteil ausgeführt. Beispielsweise kann das Stanzgitterteil im Bereich der auszubildenden Kontaktzungen nach einem ersten Stanzvorgang gewalzt oder gepresst werden, wodurch das Material dünner und breiter wird. Anschließend kann den Kontaktzungen beispielsweise durch einen weiteren Stanzvorgang oder durch Schneiden die gewünschte Form verliehen werden.

In einer Ausgestaltung sind das SMD-Bauteil und die Kontaktzungen von einer Vergussmasse umgeben. Die Vergussmasse kann beispielsweise ein Kunststoffmaterial sein, beispielsweise ein Polyester- oder Epoxidharz. Die Vergussmasse kann die Vertiefung im Wesentlichen vollständig ausfüllen. Sie kann das SMD-Bauteil allseitig umschließen. Die Vergussmasse kann auch lediglich im Bereich der Kontaktzungen und der seitlichen Kontaktflächen des SMD-Bauteils angeordnet sein. Die Vergussmasse kann das SMD-Bauteil vollständig überdecken, insbesondere einschließlich angrenzender Abschnitte der Kontaktzungen und weiterer freiliegender Abschnitte des Stanzgitterteils. Auf diese Weise werden auch das SMD-Bauteil und die Verbindung zu den Kontaktzungen dauerhaft vor Umwelteinflüssen geschützt. Insbesondere in Verbindung mit der stoffschlüssigen Verbindung zwischen den Kontaktzungen und den seitlichen Kontaktflächen wird ein außerordentlich robuster Aufbau erzielt.

In einer Ausgestaltung ist das SMD-Bauteil ein Keramikkondensator mit vier seitlichen Kontaktflächen, von denen sich jeweils zwei paarweise gegenüberliegen. Derartige Keramikkondensatoren werden als EMV-Filter eingesetzt und sind auch unter der Bezeichnung "X2Y"-Kondensator bekannt. Sie enthalten eine für Entstör- und Abschirmzwecke besonders geeignete Anordnung von Kondensatorelementen, die in einem quaderförmigen Gehäuse integriert sind. Sie sind empfindlich gegenüber mechanischen Belastungen und hohen Luftfeuchtigkeiten und können mit besonderem Vorteil in der erfindungsgemäßen Weise eingesetzt werden. Grundsätzlich eignet sich die Erfindung für beliebige SMD-Bauteile mit seitlichen Kontaktflächen, beispielsweise für herkömmliche Keramikkondensatoren mit lediglich zwei gegenüberliegenden seitlichen Kontaktflächen.

In einer Ausgestaltung ist der Träger ein Gehäuseteil eines Elektromotors und das Stanzgitterteil bildet elektrische Anschlüsse des Elektromotors. Beispielsweise kann es sich bei dem Träger um eine Endkappe eines Elektromotors handeln, die eine Aufnahme für eine Lagerkomponente oder eine Welle des Motors enthält. Der Träger ist somit kein separates, ausschließlich der Unterbringung des SMD-Bauteils dienendes Bauteil.

Die Erfindung wird nachfolgend anhand von in sieben Figuren dargestellten Ausführungsbeispielen näher erläutert. Es zeigen:
- Fig. 1: einen Schnitt durch eine erfindungsgemäße Baugruppe,
- Fig. 2: Träger und Stanzgitterteil mit Kontaktzungen der Baugruppe aus Figur 1 vor dem Einsetzen des SMD-Bauteils,
- Fig. 3: eine Ansicht von oben auf die Anordnung der Figur 2 in einer vereinfachten Darstellung vor dem Umbiegen der Kontaktzungen,
- Fig. 4: den Vorgang des Einsetzens des SMD-Bauteils in die in der Figur 2 dargestellte Anordnung,
- Fig. 5: die Anordnung aus Figur 2 mit eingesetztem SMD-Bauteil,
- Fig. 6: das Herstellen einer formschlüssigen Verbindung mittels Laserlöten,
- Fig. 7: das Herstellen von formschlüssigen Verbindungen mittels Reflow-Löten.

In allen Figuren werden für sich entsprechende Teile dieselben Bezugszeichen verwendet.

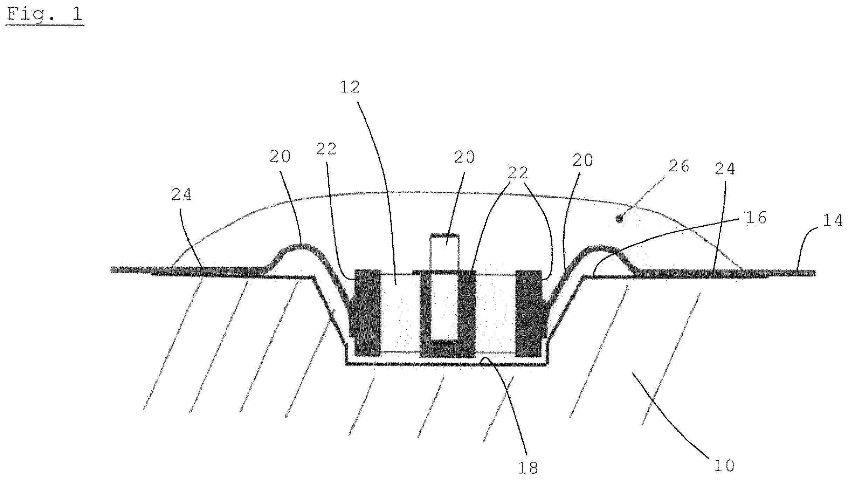

Figur 1 zeigt eine erfindungsgemäße Baugruppe mit einem Träger 10, einem SMD-Bauteil 12 und einem Stanzgitterteil 14 aus Metall.

Der Träger 10 besteht aus einem thermoplastischen Kunststoff und ist im Spritzgießverfahren hergestellt. Er hat eine Oberseite 16 und eine Vertiefung 18, die in der Oberseite 16 ausgebildet ist.

In der Vertiefung 18 ist das SMD-Bauteil 12 angeordnet. Es steht geringfügig über die Oberseite 16 über.

Das Stanzgitterteil 14 weist vier Kontaktzungen 20 auf, von denen in der Figur drei erkennbar sind. Die Kontaktzungen 20 ragen mit ihren freien Enden in die Vertiefung 18 hinein und liegen an seitlichen Kontaktflächen 22 des SMD-Bauteils 12 federnd an. Die an den seitlichen Kontaktflächen 22 des SMD-Bauteils 12 anliegenden freien Enden der Kontaktzungen 20 sind mit den seitlichen Kontaktflächen 22 formschlüssig verbunden, und zwar im dargestellten Beispiel durch Löten.

Das Stanzgitterteil 14 umfasst neben den Kontaktzungen 20 von den Kontaktzungen 20 entfernte Abschnitte 24. Diese Abschnitte 24 definieren eine Ebene und sind mit der Oberseite 16 des Trägers 10 verklebt.

Die gesamte Anordnung ist mit einer Vergussmasse 26 vergossen. Diese umgibt das SMD-Bauteil 12 und füllt die nach unten geschlossene Vertiefung 18 vollständig aus, wobei auch die Kontaktzungen 20 vollständig von der Vergussmasse 26 umschlossen und überdeckt werden. Von den Kontaktzungen 20 entfernte Abschnitte des Stanzgitterteils 14 sind nicht mit der Vergussmasse 26 bedeckt. Sie dienen zur Herstellung einer Verbindung zu weiteren Funktionselementen der Baugruppe.

Im dargestellten Ausführungsbeispiel handelt es sich bei dem SMD-Bauteil 12 um einen sogenannten X2Y-Keramikkondensator, der als EMV-Filter für einen Elektromotor, insbesondere einen Gleichstromelektromotor mit Bürsten, verwendet wird. Der Träger 10 ist ein Teil einer Endkappe eines Gehäuses dieses Elektromotors. Die in der Figur 1 rechts und links dargestellten, von den Kontaktzungen 20 entfernten Abschnitte 24 des Stanzgitterteils 14 sind unmittelbar mit den Bürstenträgern (nicht gezeigt) des Elektromotors verbunden. Die beiden zu diesen rechts und links dargestellten Abschnitten 24 gehörenden Kontaktzungen 20 sind einteilig mit dem Stanzgitterteil 14 gefertigt und liegen an zwei gegenüberliegenden seitlichen Kontaktflächen 22 des SMD-Bauteils 12 an. Die beiden übrigen seitlichen Kontaktflächen 22 des SMD-Bauteils 12, die in der Figur 1 einerseits dem Betrachter zugewandt sind und andererseits auf der Rückseite der Anordnung liegen, sind über weitere Kontaktzungen 20 mit Masse verbunden.

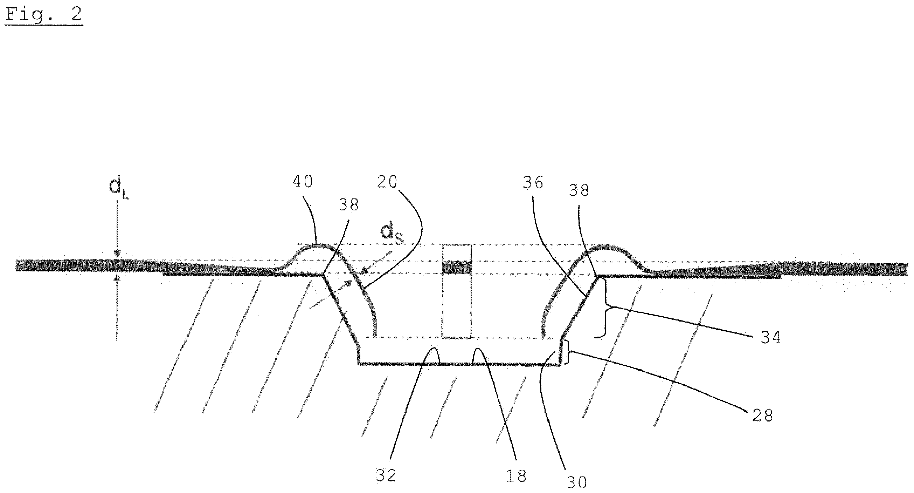

Weitere Einzelheiten der Vertiefung 18 und des Stanzgitterteils 14 werden anhand der Figur 2 näher erläutert, die die Anordnung aus Figur 1 vor dem Einsetzen des SMD-Bauteils 12 zeigt. Die Vertiefung 18 hat in einer parallel zur Oberseite 16 des Trägers 10 verlaufenden Schnittebene einen rechteckigen Querschnitt. In einem unteren Abschnitt 28 der Vertiefung 18 ändert sich dieser Querschnitt mit dem Abstand von der Oberseite 16 nicht und die seitlichen Wandflächen 32 sind in diesem unteren Abschnitt 28 senkrecht zum Boden 32 der Vertiefung 18 angeordnet.

Unmittelbar oberhalb des unteren Abschnitts 28 weist die Vertiefung 18 einen oberen Abschnitt 34 auf, in dem die seitlichen Wandflächen 30 gegenüber der Oberseite 16 in einem Winkel von ca. 120° geneigt angeordnet sind. Diese geneigten Abschnitte 36 der seitlichen Wandflächen 30 führen bis zur Oberseite 16 des Trägers, wo ein Rand 38 der Vertiefung 18 ausgebildet ist.

Das Stanzgitterteil 14 weist in seinen von den Kontaktzungen 20 entfernten Abschnitten 24 eine Materialstärke d_{L} von ungefähr 0,6 mm auf. In Richtung zu den Kontaktzungen 20 hin nimmt diese Materialstärke kontinuierlich bis auf die Materialstärke d_{S} im Bereich der Kontaktzungen 20 ab, die ungefähr 0,2 mm beträgt.

Diese Materialstärke d_{S} erreicht das Stanzgitterteil 14 in einem Abstand vom Rand 38 der Vertiefung. An diesem Punkt sind die Kontaktzungen zunächst nach oben gekrümmt, und es schließt sich ein gekrümmter Abschnitt 40 der Kontaktzungen 20 an, der annähernd kreisbogenförmig um den Rand 38 der Vertiefung 18 herum gekrümmt ist. Ungefähr am Ende dieses gekrümmten Abschnitts 40 durchstoßen die Kontaktzungen 20 die Ebene der Oberseite 16 und ragen nach unten in die Vertiefung 18 hinein, und zwar etwa bis zur Grenze zwischen dem unteren Abschnitt 28 und dem oberen Abschnitt 34 der Vertiefung 18. Der gekrümmte Abschnitt 40 sowie der weitere Verlauf der Kontaktzungen 20 bis zu ihren freien Enden 42 hält einen annähernd gleichmäßigen Abstand vom Träger 10 ein. Dieser Abschnitt beträgt ca. 1 mm.

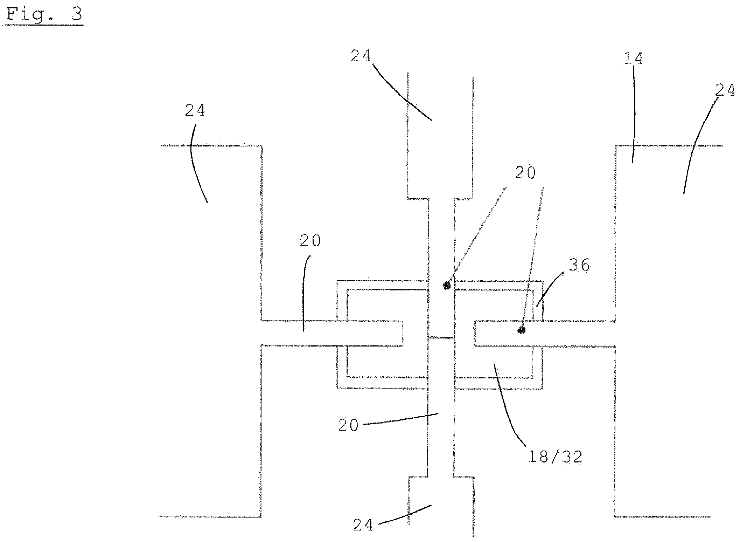

Figur 3 zeigt die Anordnung aus Figur 2 in einer Ansicht von oben. Man erkennt die Oberseite 16 des Trägers 10 und das Stanzgitterteil 14 mit seinen insgesamt vier Kontaktzungen 20, die in die Vertiefung 18 hineinragen. Die von den Kontaktzungen 20 entfernten Abschnitte 24 des Stanzgitterteils 14 sind ohne weitere elektrische Verbindungsmittel wie Kabel oder Drähte oder dergleichen mit weiteren, in der Figur nicht dargestellten Funktionselementen der Baugruppe elektrisch leitend verbunden. Dies ist in der Figur 3 nicht dargestellt. Gut zu erkennen ist, dass die Kontaktzungen 20 eine gleichmäßige Breite aufweisen. Diese Breite liegt beispielsweise im Bereich von 0,6 mm bis 2,0 mm.

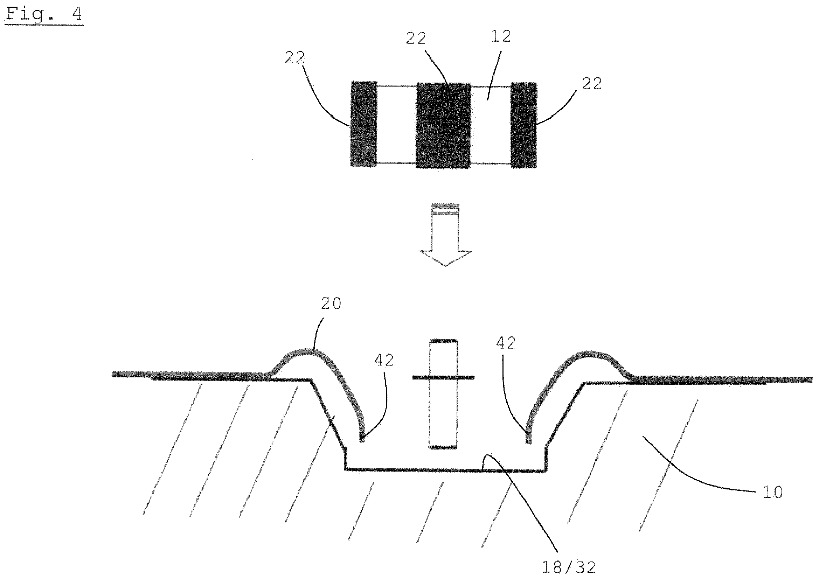

Figur 4 veranschaulicht das Einsetzen des SMD-Bauteils 12 in die Vertiefung 18 mit den Kontaktzungen 20. Ebenfalls gut erkennbar sind die seitlichen Kontaktflächen 22 des SMD-Bauteils 12. Der Abstand zwischen den freien Enden 42 der Kontaktzungen 20 ist etwas kleiner als die Länge des SMD-Bauteils 12 zwischen den zugehörigen seitlichen Kontaktflächen 22, damit die freien Enden 42 der Kontaktzungen 20 federnd an den seitlichen Kontaktflächen 22 anliegen. Gut erkennbar ist, dass die freien Enden 42 der Kontaktzungen 20 einen Abstand vom Boden 32 der Vertiefung 18 einhalten. Dies schützt sie vor Beschädigung, wenn sie beim Einsetzen des SMD-Bauteils 12 in die Vertiefung 18 verformt werden.

Nicht dargestellt ist in der Figur 4, dass die dem SMD-Bauteil 12 zugewandten Flächen der Kontaktzungen 20 und die seitlichen Kontaktflächen 22 des SMD-Bauteils 12 verzinnt sind, sodass sie durch nachträgliches Erhitzen stoffschlüssig miteinander verbunden werden können.

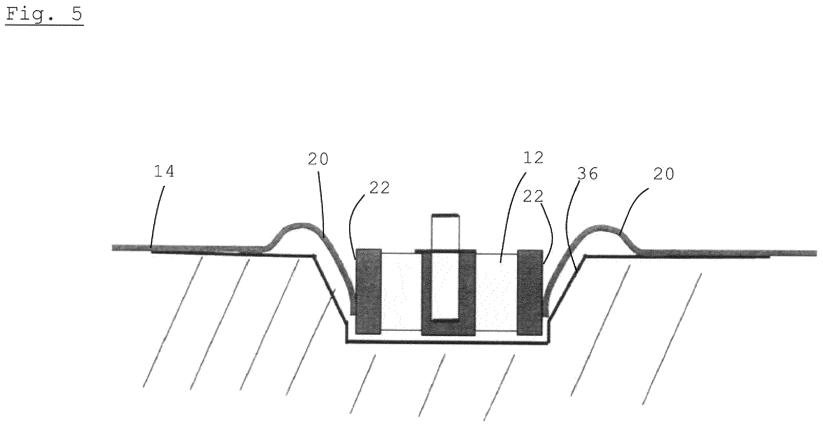

Figur 5 zeigt den Zustand der Baugruppe nach dem Einsetzen des SMD-Bauteils 12 in die Vertiefung 18. Erkennbar ist, dass die Kontaktzungen 20 federnd an den seitlichen Kontaktflächen 22 des SMD-Bauteils 12 anliegen und trotz ihrer Verformung in Richtung zu den seitlichen Wandflächen 30 hin einen Abstand von diesen einhalten.

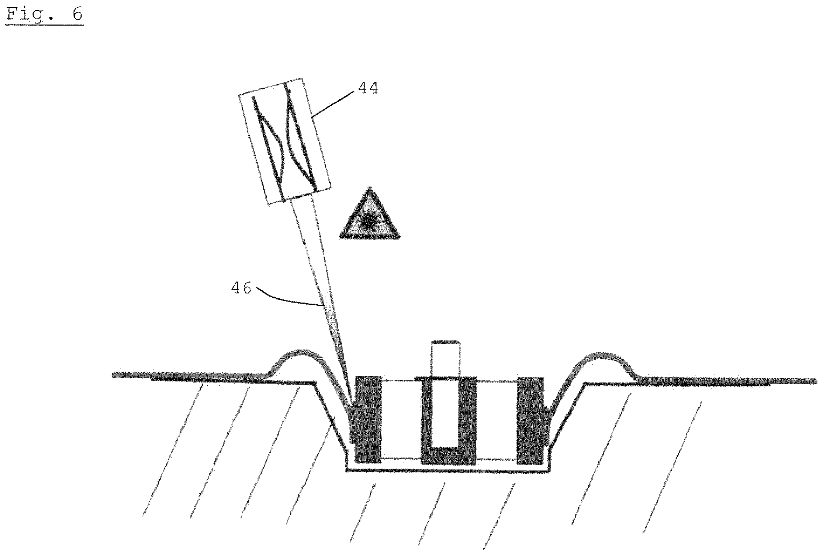

Figur 6 veranschaulicht, wie das Löten erfolgen kann. Dargestellt ist schematisch eine Laserlöteinrichtung 44, die den Kontaktbereich zwischen Kontaktzunge 20 und seitlicher Kontaktfläche 22 mit einem Laserstrahl 46 erhitzt.

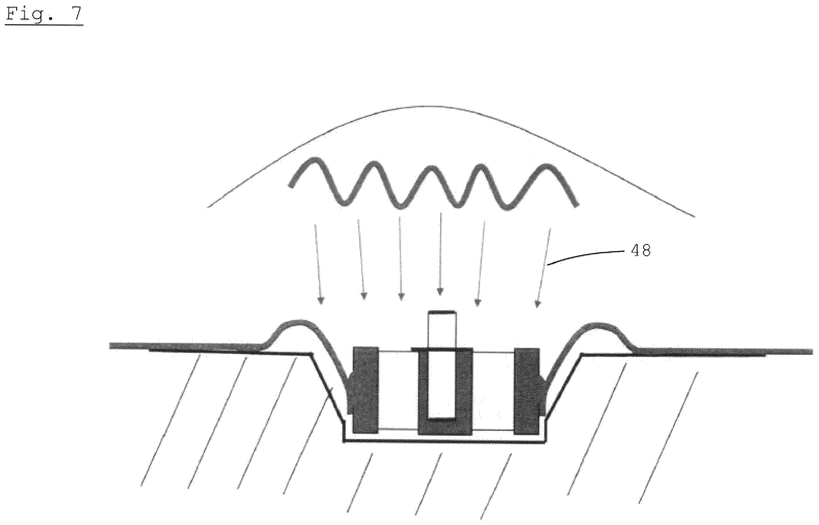

Alternativ können die zuvor verzinnten Flächen im Reflow-Lötverfahren verlötet werden. Dies ist in der Figur 7 schematisch dargestellt, wobei die Hitzeeinwirkung durch Pfeile 48 veranschaulicht wird.

Nach dem Abschluss der in den Figuren 6 oder 7 dargestellten Lötschritte wird eine Vergussmasse 26 aufgebracht, sodass sich der in der Figur 1 dargestellte Endzustand ergibt.

## Patentansprüche

1. Baugruppe mit
- einem Träger (10) aus einem elektrisch isolierenden Material,
- einem SMD-Bauteil (12), das seitliche Kontaktflächen (22) aufweist, und
- einem Stanzgitterteil (14) aus Metall, das an dem Träger (10) befestigt ist und zur Herstellung von elektrischen Verbindungen zwischen den seitlichen Kontaktflächen (22) des SMD-Bauteils (12) und weiteren Funktionselementen der Baugruppe dient,
wobei das Stanzgitterteil (14) Kontaktzungen (20) aufweist, die federnd an den seitlichen Kontaktflächen (22) anliegen und stoffschlüssig mit den seitlichen Kontaktflächen (22) verbunden sind, und wobei der Träger (10) eine in einer Oberseite (16) ausgebildete Vertiefung (18) aufweist, in der das SMD-Bauteil (12) angeordnet ist und in die die Kontaktzungen (20) hineinragen,
**dadurch gekennzeichnet, dass** die Vertiefung (18) einen Boden (32) und seitliche Wandflächen (30) aufweist und die Kontaktzungen (20) in einem Abstand von den seitlichen Wandflächen (30) angeordnet sind.

2. Baugruppe nach Anspruch 1, **dadurch gekennzeichnet, dass** der Träger (10) im Spritzgießverfahren hergestellt ist.

3. Baugruppe nach Anspruch 2, **dadurch gekennzeichnet, dass** der Träger (10) im Spritzgießverfahren mit dem Stanzgitterteil (14) verbunden ist.

4. Baugruppe nach einem der Ansprüche 1 bis 2, **dadurch gekennzeichnet, dass** das Stanzgitterteil (14) mit dem Träger (10) verklebt ist.

5. Baugruppe nach einem der Ansprüche 1 bis 4, **dadurch gekennzeichnet, dass** das Stanzgitterteil (14) an der Oberseite (16) des Trägers (10) befestigt ist.

6. Baugruppe nach einem der Ansprüche 1 bis 5, **dadurch gekennzeichnet, dass** die Kontaktzungen (20) von der Oberseite (16) aus in die Vertiefung (18) hineinragen.

7. Baugruppe nach einem der Ansprüche 1 bis 6, **dadurch gekennzeichnet, dass** die seitlichen Wandflächen (30) im Bereich der Kontaktzungen (20) geneigt angeordnet sind, so dass ein Winkel zwischen einer seitlichen Wandfläche (30) und einer angrenzenden Oberseite (16) im Bereich von 95° bis 140° liegt.

8. Baugruppe nach einem der Ansprüche 1 bis 7, **dadurch gekennzeichnet, dass** an mindestens zwei Seiten der Vertiefung (18) jeweils mindestens eine Kontaktzunge (20) angeordnet ist.

9. Baugruppe nach einem der Ansprüche 1 bis 8, **dadurch gekennzeichnet, dass** die Kontaktzungen (20) einen Abschnitt (40) aufweisen, der um einen Rand (38) der Vertiefung (18) herum gekrümmt ist und in einem Abstand von dem Rand (38), von einer seitlichen Wandfläche (30) der Vertiefung (18) und von der Oberseite (16) des Trägers (10) angeordnet ist.

10. Baugruppe nach einem der Ansprüche 1 bis 9, **dadurch gekennzeichnet, dass** die Kontaktzungen (20) eine Materialstärke (d_{S}) aufweisen, die geringer ist als die Materialstärke (d_{L}) des Stanzgitterteils (14) in einem von der Vertiefung (18) entfernten Abschnitt (24).

11. Baugruppe nach einem der Ansprüche 1 bis 10, **dadurch gekennzeichnet, dass** die Kontaktzungen (20) durch Verformen und Schneiden eines Stanzgitterteils (14) einstückig mit dem Stanzgitterteil (14) ausgeführt sind.

12. Baugruppe nach einem der Ansprüche 1 bis 11,**dadurch gekennzeichnet, dass** das SMD-Bauteil (12) und die Kontaktzungen (20) von einer Vergussmasse (26) umgeben sind.

13. Baugruppe nach einem der Ansprüche 1 bis 12, **dadurch gekennzeichnet, dass** das SMD-Bauteil (12) ein Keramikkondensator mit vier seitlichen Kontaktflächen (22) ist, von denen sich jeweils zwei paarweise gegenüberliegen.

14. Baugruppe nach einem der Ansprüche 1 bis 13, **dadurch gekennzeichnet, dass** der Träger (10) ein Gehäuseteil eines Elektromotors ist und das Stanzgitterteil (14) bildet elektrische Anschlüsse des Elektromotors.

## Claims

1. Assembly comprising:
- a substrate (10) that is embodied from an electrically insulating material,
- an SMD component (12) that comprises lateral contact surfaces (22), and
- a stamped lead frame part (14) that is embodied from metal and is fastened to the substrate (10) and is used to establish electrical connections between the lateral contact surfaces (22) of the SMD component (12) and further functional elements of the assembly,
wherein the stamped lead frame part (14) comprises contact tongues (20) that lie in a resilient manner against the lateral contact surfaces (22) and are connected by means of a positive material connection to the lateral contact surface (22), and wherein the substrate (10) comprises a depression (18) that is formed in an upper face (16), the SMD component (12) being arranged in said depression and the contact tongues (20) protruding into said depression, **characterized in that** the depression (18) comprises a base (32) and lateral wall faces (30) and the contact tongues (20) are arranged at a distance from the lateral wall faces (30).

2. Assembly according to Claim 1, **characterized in that** the substrate (10) is produced in the injection molding process.

3. Assembly according to Claim 2, **characterized in that** the substrate (10) is connected to the stamped lead frame part (14) in the injection molding process.

4. Assembly according to any one of Claims 1 to 2, **characterized in that** the stamped lead frame part (14) is adhered to the substrate (10).

5. Assembly according to any one of Claims 1 to 4, **characterized in that** the stamped lead frame part (14) is fastened to the upper face (16) of the substrate (10).

6. Assembly according to any one of Claims 1 to 5, **characterized in that** the contact tongues (20) protrude out from the upper face (16) into the depression (18).

7. Assembly according to any one of Claims 1 to 6, **characterized in that** the lateral wall faces (30) are arranged in an inclined manner in the region of the contact tongues (20), so that an angle in the range from 95° to 140° is produced between a lateral wall face (30) and an adjoining upper face (16).

8. Assembly according to any one of Claims 1 to 7, **characterized in that** at least one contact tongue (20) is arranged on at least two sides of the depression (18) in each case.

9. Assembly according to any one of Claims 1 to 8, **characterized in that** the contact tongues (20) comprise a portion (40) that is curved around an edge (38) of the depression (18) and is arranged at a distance from the edge (38), from a lateral wall face (30) of the depression (18) and from the upper face (16) of the substrate (10).

10. Assembly according to any one of Claims 1 to 9, **characterized in that** the contact tongues (20) comprise a material thickness (dₛ) that is less than the material thickness (d_{L}) of the stamped lead frame part (14) in a portion (24) that is remote from the depression (18).

11. Assembly according to any one of Claims 1 to 10, **characterized in that** the contact tongues (20) are embodied in one piece with the stamped lead frame part (14) by means of reshaping and cutting a stamped lead frame part (14).

12. Assembly according to any one of Claims 1 to 11, **characterized in that** the SMD component (12) and the contact tongues (20) are encased by an encapsulation compound (26).

13. Assembly according to any one of Claims 1 to 12, **characterized in that** SMD component (12) is a ceramic condenser having four lateral contact surfaces (22), of which in each case two lie as a pair opposite one another.

14. Assembly according to any one of Claims 1 to 13, **characterized in that** the substrate (10) is a housing part of an electric motor and the stamped lead frame part (14) establishes electrical connections of the electric motor.

## Revendications

1. Module comprenant
- un support (10) en matériau électriquement isolant,
- un composant SMD (12), qui présente des surfaces de contact latérales (22), et
- une partie en treillis métallique (14) qui est fixée au support (10) et qui sert à établir des connexions électriques entre les surfaces de contact latérales (22) du composant SMD (12) et d'autres éléments fonctionnels du module,
la partie en treillis métallique (14) présentant des langues de contact (20) qui s'appliquent de manière élastique contre les surfaces de contact latérales (22) et qui sont connectées par liaison de matière aux surfaces de contact latérales (22), et le support (10) présentant un renfoncement (18) réalisé dans un côté supérieur (16), dans lequel est disposé le composant SMD (12), et dans lequel pénètrent les langues de contact (20),
**caractérisé en ce que** le renfoncement (18) présente un fond (32) et des surfaces de paroi latérales (30) et les langues de contact (20) sont disposées à distance des surfaces de paroi latérales (30).

2. Module selon la revendication 1, **caractérisé en ce que** le support (10) est fabriqué par un procédé de moulage par injection.

3. Module selon la revendication 2, **caractérisé en ce que** le support (10) est connecté à la partie en treillis (14) par un procédé de moulage par injection.

4. Module selon l'une quelconque des revendications 1 et 2, **caractérisé en ce que** la partie en treillis (14) est collée au support (10).

5. Module selon l'une quelconque des revendications 1 à 4, **caractérisé en ce que** la partie en treillis (14) est fixée au côté supérieur (16) du support (10).

6. Module selon l'une quelconque des revendications 1 à 5, **caractérisé en ce que** les langues de contact (20) pénètrent depuis le côté supérieur (16) dans le renfoncement (18).

7. Module selon l'une quelconque des revendications 1 à 6, **caractérisé en ce que** les surfaces de paroi latérales (30) sont disposées de manière inclinée dans la région des langues de contact (20), de telle sorte qu'un angle entre une surface de paroi latérale (30) et un côté supérieur adjacent (16) soit compris dans une plage de 95° à 140°.

8. Module selon l'une quelconque des revendications 1 à 7, **caractérisé en ce qu'**à chaque fois au moins une langue de contact (20) est disposée au niveau d'au moins deux côtés du renfoncement (18).

9. Module selon l'une quelconque des revendications 1 à 8, **caractérisé en ce que** les langues de contact (20) présentent une portion (40) qui est courbée autour d'un bord (38) du renfoncement (18) et qui est disposée à distance du bord (38), d'une surface de paroi latérale (30) du renfoncement (18) et du côté supérieur (16) du support (10).

10. Module selon l'une quelconque des revendications 1 à 9, **caractérisé en ce que** les langues de contact (20) présentent une épaisseur de matériau (d_{S}) qui est inférieure à l'épaisseur de matériau (d_{L}) de la partie en treillis (14) dans une portion (24) éloignée du renfoncement (18).

11. Module selon l'une quelconque des revendications 1 à 10, **caractérisé en ce que** les langues de contact (20) sont réalisées par formage et découpe d'une partie en treillis (14) d'une seule pièce avec la partie en treillis (14).

12. Module selon l'une quelconque des revendications 1 à 11, **caractérisé en ce que** le composant SMD (12) et les langues de contact (20) sont entourés par une masse de scellement (26) .

13. Module selon l'une quelconque des revendications 1 à 12, **caractérisé en ce que** le composant SMD (12) est un condensateur en céramique avec quatre surfaces de contact latérales (22) dont à chaque fois deux sont opposées par paire.

14. Module selon l'une quelconque des revendications 1 à 13, **caractérisé en ce que** le support (10) est une partie de boîtier d'un moteur électrique et la partie en treillis (14) forme des raccords électriques du moteur électrique.
